Europäisches Patentamt

European Patent Office

Office européen des brevets

(19)

(11) Publication number: **0 411 298 A1**

# EUROPEAN PATENT APPLICATION

(12)

(21) Application number: **90111829.9**

(22) Date of filing: **22.06.90**

(51) Int. Cl.⁵: **C23C 14/24**, C23C 16/26

(30) Priority: **31.07.89 US 386737**

(43) Date of publication of application:
**06.02.91 Bulletin 91/06**

(84) Designated Contracting States:
**BE DE FR GB SE**

(71) Applicant: **GENERAL ELECTRIC COMPANY**
**1 River Road**
**Schenectady New York 12305(US)**

(72) Inventor: **Anthony, Thomas Richard**
**2142 Lynnwood Drive**
**Schenectady, New York 12309(US)**
Inventor: **Fleisher, James Fulton**
**4 Woodside Drive**
**Scotia, New York 12302(US)**

(74) Representative: **Catherine, Alain**
**General Electric France Service de Propriété**
**Industrielle 18 Rue Horace Vernet**
**F-92136 Issy-Les-Moulineaux Cedex(FR)**

(54) **Method for improving adhesion of synthetic diamond coatings to substrates.**

(57) Adhesion of diamond coatings formed by chemical vapor deposition to substrates, particularly molybdenum substrates, is improved by first applying to the substrate a silicon layer. Preferably, the silicon layer is applied via an auxiliary substrate comprising elemental or chemically combined silicon, from which a silane diffuses to the principal substrate, where it is reduced to silicon and deposits thereon.

EP 0 411 298 A1

## METHOD FOR IMPROVING ADHESION OF SYNTHETIC DIAMOND COATINGS TO SUBSTRATES

This invention relates to the chemical vapor deposition of diamond, and more particularly to the improvement of adhesion to a substrate of a diamond coating thus deposited.

Various methods are known for the synthetic production of diamond. In particular, the deposition of diamond coatings on substrates to produce cutting and abrasive tools is known.

One class of methods developed in recent years for synthetic diamond deposition consists of the chemical vapor deposition (hereinafter sometimes "CVD") methods. For a general summary of various diamond deposition methods including CVD methods, reference is made to Chemical & Engineering News , 67 (20) , 24-39 (May 15, 1989), incorporated herein by reference.

In the CVD methods, a mixture of hydrogen and a hydrocarbon gas such as methane is thermally activated and passed into contact with a substrate. The hydrogen gas is converted to atomic hydrogen which reacts with the hydrocarbon to form elemental carbon, which deposits on the substrate in the form of diamond. Many of the CVD diamond coating methods, hereinafter referred to as "filament" methods, employ one or more resistance heating units including heated wires or filaments, typically at temperatures of at least 2000°C, to provide the high activation temperatures at which these conversions take place.

Relatively thick diamond coatings are required in the manufacture of such articles as cutting tools. However, a problem which often arises is the failure of thick diamond coatings to adhere to the substrate, as a result of differences in coefficient of thermal expansion between the diamond and the substrate material.

Thus, for example, cutting tools comprising a diamond layer on molybdenum are often desired. The coefficients of thermal expansion of diamond and molybdenum are so different that stresses are produced in the coating article as it cools from the temperature at which diamond deposition takes place. Thin diamond coatings are usually elastic enough to withstand such stresses, but thick coatings of the type desired on cutting tools may cause separation of diamond from the molybdenum substrate and/or catastrophic failure of the diamond layer in the form of severe cracking and fragmentation.

The present invention provides a method for improving adhesion between CVD produced diamond and substrates such as those of molybdenum. It also provides improved diamond-coated articles produced by said method.

In one of its aspects, therefore, the invention is a method for improving adhesion of a diamond coating produced by chemical vapor deposition on at least one substrate which comprises first applying to said substrate a layer of elemental silicon, and subsequently depositing said diamond coating on said silicon layer.

The CVD method for diamond deposition is known in the art and disclosed in many patents and publications, and therefore it need not be dealt with in detail here. In brief, it involves the passage of a mixture of hydrogen and a hydrocarbon gas, normally methane, the latter comprising up to about 2% of said mixture, into a chamber containing one or more substrates to receive the diamond coating. The conditions employed are such as to activate the gas mixture by converting molecular hydrogen to atomic hydrogen, and this may be achieved by such means as high frequency and thermal excitation.

It is often convenient to employ one or more heated filaments in the deposition chamber to achieve temperatures on the order of 2000°C or above, thus causing the formation of atomic hydrogen and deposition of the desired diamond layer. The material of which said filaments are comprised is not critical, any material known in the art as suitable for this purpose being acceptable. Illustrative materials are metallic tungsten, tantalum, molybdenum and rhenium; because of its relatively low cost and particular suitability, tungsten is often preferred. Filament diameters of about 0.2-1.0 mm. are typical, with about 0.8 mm. frequently being preferred.

Normally, the deposition chamber is maintained at reduced pressure, for example about 10 torr. The effluent gases are withdrawn by means of a vacuum pump or its equivalent. The orientation of the substrate and filament(s) in the chamber is not critical to the invention and may be horizontal or vertical. The filament may be in any shape such as straight, curved or spiral. Likewise, the shape, orientation and location in the deposition chamber of the substrate(s) is not critical.

Any substrate material suitable for diamond deposition thereon may be employed in the present invention. Examples of such materials are boron, boron nitride, platinum, graphite, molybdenum, copper, aluminum nitride, silver, iron, nickel, silicon, alumina and silica, as well as combinations thereof. Because the problem addressed by the invention is the result of differences in coefficient of thermal expansion between the substrate and the diamond deposited thereon, the invention is particularly useful with substrates which are characterized by large differences therein. A substrate material which is particularly notable in this respect is molybdenum, and therefore the invention is especially useful for the CVD coating of diamond on molybdenum substrates. To distinguish the above-described substrate from the silicon-containing substrate optionally employed as described hereinafter, the two are sometimes hereinafter respectively designated "principal substrate" and "auxiliary substrate".

The essential feature of the invention is the deposition of a layer of elemental silicon on the substrate(s) prior to the formation of the diamond coating. Silicon can be provided in several ways, many of which involve the conversion of a silane to elemental silicon by a reaction parallel to that which converts the hydrocarbon to elemental carbon during CVD deposition. Thus, for example, it is within the scope of the invention to initiate the CVD process by contacting the substrate with a gas mixture which contains, in addition to the required hydrogen and hydrocarbon, a silane, most often SiH₄. After diamond deposition on the silicon layer has begun, it continues until the entire substrate is coated, at which point it is obviously impossible for further silicon to be deposited on the principal substrate; therefore, silane addition can be discontinued after the required silicon layer is present.

In a preferred embodiment of the invention, the silicon source is an auxiliary substrate comprising silicon in elemental or combined form. By "combined form" is meant a compound of silicon which is capable of conversion by elemental or atomic hydrogen, under conditions for the CVD deposition of diamond, to a silane. Silicon carbide is often the preferred auxiliary substrate material. Said silane then diffuses to the principal substrate, where it is further converted to silicon and deposits thereon.

Of course, diamond is deposited on both the principal and the auxiliary substrate, whereby silane formation and diffusion is eventually rendered impossible. This is acceptable since the thickness of said layer is not critical, layers approaching monoatomic thickness apparently being adequate to enhance adhesion.

The effect of the silicon layer provided by the method of this invention is to improve adhesion of the diamond coating to the principal substrate. This is particularly noticeable when said substrate is molybdenum, and in that case is believed to involve two effects. The first effect is the reaction of the silicon layer with molybdenum to form molybdenum silicide. When diamond is deposited directly on molybdenum, a molybdenum carbide layer is formed; molybdenum silicide is much more adherent to elemental molybdenum than is molybdenum carbide. The second effect is the higher degree of adhesion of diamond to silicon than to molybdenum.

Prior to the present invention, diamond coatings on molybdenum could be deposited with a thickness only on the order of 10-20 microns before separation from the molybdenum took place. The present invention permits the deposition and adherence of layers with a thickness of at least 100 microns. Articles comprising a substrate with an adherent CVD diamond coating of this thickness on at least a portion thereof are another aspect of the invention.

The method of this invention is illustrated by an example in which two flat substrates, one of molybdenum and the other of silicon carbide, were placed parallel to each other on opposite sides of a tungsten filament at distances from the filament of about 10 mm., in a closed reaction chamber having a gas inlet and an exhaust port. The chamber was evacuated and the filament was heated to about 2000°C, after which a mixture of 98% (by weight) hydrogen and 2% methane was introduced into the chamber at a pressure of about 10 torr. Over a four-week period, passage of the hydrogen-methane mixture and heating of the filament were continued as a diamond film was grown on each of the substrates. At the end of this time, a 300-micron layer of diamond had deposited on the molybdenum substrate, with good adhesion thereto.

## Claims

1. A method for improving adhesion of a diamond coating produced by chemical vapor deposition on at least one substrate which comprises first applying to said substrate a layer of elemental silicon, and subsequently depositing said diamond coating on said silicon layer.

2. A method according to claim 1 wherein the substrate comprises molybdenum.

3. A method according to claim 2 wherein the silicon layer is formed by the conversion of a silane to elemental silicon.

4. A method according to claim 3 wherein the substrate is contacted with a gas mixture comprising hydrogen, a hydrocarbon and a silane.

5. A method according to claim 3 wherein the silane is provided by an auxiliary substrate comprising silicon in elemental or combined form.

6. A method according to claim 5 wherein the auxiliary substrate comprises silicon carbide.

7. An article comprising a substrate with an adherent diamond coating with a thickness of at least 100 microns, produced by chemical vapor deposition, on at least a portion thereof.

8. An article according to claim 7 wherein the substrate comprises molybdenum.

9. An article according to claim 8 further comprising an intermediate adhesion promoting layer comprising molybdenum silicide and elemental silicon.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN, unexamined applications, P section, vol. 12, no. 233, July 5, 1988 THE PATENT OFFICE JAPANESE GOVERNMENT page 74 P 724 * Kokai-no. 63-25 662 (FUJI ELECTRIC) * | 1,3,4 | C 23 C 14/24 C 23 C 16/26 |
| X | EP - A1 - 0 245 688 (NISSIN ELECTRIC COMPANY) * Claims 1,2 * | 1,3,4 | |
| A | PATENT ABSTRACTS OF JAPAN, unexamined applications, C section, vol. 11, no. 365, November 27, 1987 THE PATENT OFFICE JAPANESE GOVERNMENT page 148 C 460 * Kokai-no. 62-138 395 (KOYCERA CORP) * | 1,4 | **TECHNICAL FIELDS SEARCHED (Int. Cl.5)** C 23 C |
| A | WO - A1 - 88/07 599 (SHOWA DENKO KABUSHIKI KAISHA) * Abstract * | 1 | |

The present search report has been drawn up for all claims

| Place of search | Date of completion of the search | Examiner |
|---|---|---|
| VIENNA | 29-10-1990 | WILFLINGER |